# EUROPEAN PATENT SPECIFICATION

(11) **EP 2 457 880 B1**
(45) Date of publication and mention of the grant of the patent: **05.03.2014**
(21) Application number: 10306303.8
(22) Date of filing: 26.11.2010
(51) Int. Cl.: C03B 23/02, B81C 99/00

(54) **Fluidic module fabrication with heterogeneous channel-forming laminates**
Fluidische Modulherstellung mit heterogenen kanalbildenden Laminaten
Fabrication de module fluidique avec stratifiés hétérogènes formant des canaux

(43) Date of publication of application: 30.05.2012
(73) Proprietor: Corning Incorporated, Corning NY 14831 (US)
(72) Inventor: Groult, Aline Martine Marie, 77370 Nangis (FR); Marques, Paulo Gaspar Jorge, 77300 Fontainebleau (FR); Sellam, Armand, 91120 Palaiseau (FR)
(74) Representative: Le Roux, Martine

(56) References cited:
- EP-A1- 1 964 817
- EP-A2- 1 964 818
- US-A1- 2010 126 222

## Description

### BACKGROUND

### Field of the Invention

The present disclosure relates in general to the manufacture of advanced flow reactors including, but not limited to, micro-reactors, mini-reactors, and any type of continuous flow reactor employing one or more glass or glass-ceramic fluidic modules. The term "flow reactor" is commonly utilized to refer to a device in which a moving or static target sample is confined in a micro-channel or a network of fluid channels and subject to analysis. Typically, the analysis involves chemical reactions and the dimensions of the confined space are on the order of about 1 mm or less. Microchannels are the most typical form of such confinement and the microreactor is usually a continuous flow reactor, as opposed to a batch reactor. Microreactors offer many advantages over conventional scale reactors, including vast improvements in energy efficiency, reaction speed, reaction yield, safety, reliability, scalability, etc. Microreactors are also identified in the art as microstructured reactors, microchannel reactors, or microfluidic devices.

### Technical Background

Individual fluidic modules can be interconnected to define a microreactor assembly in the form of a continuous flow reactor. The fluidic module is commonly formed by stacking a plurality of glass sheets to define one or more extended fluidic channels or a network of inter-connected or thermally coupled fluidic channels. International patent publications WO 2008/106160 and WO 2008/106160 present methods for making microfluidic devices where a **patterned** molding surface is employed to form fluidic channel components in the device. European patent application EP 1 964 818 presents a method for making microfluidic devices having increased average thermal conductivity utilizing a glass frit and a high thermal conductivity filler. Each of the aforementioned publications present fabrication methodology that may, given the teachings of the present disclosure, be adapted for use in practicing aspects of the present disclosure.

### BRIEF SUMMARY

According to the subject matter of the present disclosure, methods are provided for fabricating fluidic modules that can be used in the assembly of continuous flow reactors. Fluidic modules and reactors formed there from are also contemplated.

In accordance with one embodiment of the present disclosure, a method is provided for fabricating a fluidic module comprising fluidic channels defined within a glass or glass-ceramic structure. According to the method, a heterogeneous channel-forming laminate is provided comprising a mold-engaging layer and a laminate backbone. The laminate backbone comprises a vitreous body defining a supportive viscosity µ_{B}. A channel-forming mold is pressed into engagement with the mold-engaging layer of the channel forming laminate at a molding temperature T_{M} to form fluidic channel components in the channel-forming laminate. The molding viscosity µ_{M} of the mold-engaging layer is less than the supportive viscosity µ_{B} of the laminate backbone at the molding temperature T_{M}. The pressed channel-forming laminate is stacked with a plurality of complementary pressed channel forming laminates to define a plurality of fluidic channels in a stacked laminate structure. The plurality of fluidic channels in the stacked laminate structure is sealed at a sealing temperature T_{S} that is less than the molding temperature T_{M} and above a softening point temperature of the mold-engaging layer.

In accordance with another embodiment of the present disclosure, a fluidic module comprising a stacked laminate structure is provided. The stacked laminate structure comprise a stacked plurality of complementary channel forming laminates defining a plurality of fluidic channels. The fluidic module is as defined in appended claims 14 and 15.

### BRIEF DESCRIPTION OF THE SEVERAL VIEWS OF THE DRAWINGS

The following detailed description of specific embodiments of the present disclosure can be best understood when read in conjunction with the following drawings, where like structure is indicated with like reference numerals and in which:
Fig. 1 illustrates a channel forming laminate and channel forming mold according to one aspect of the present disclosure;
Fig. 2 illustrates a channel forming laminate engaged by a channel forming mold according to one aspect of the present disclosure;
Fig. 3 illustrates a pressed channel forming laminate according to one aspect of the present disclosure; and
Fig. 4 illustrates a fluidic modules according to one aspect of the present disclosure.

### DETAILED DESCRIPTION

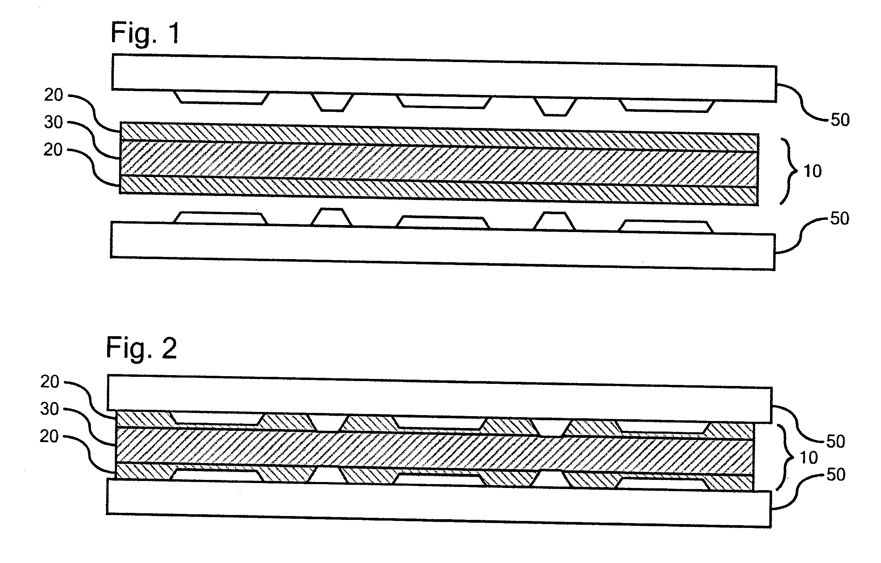

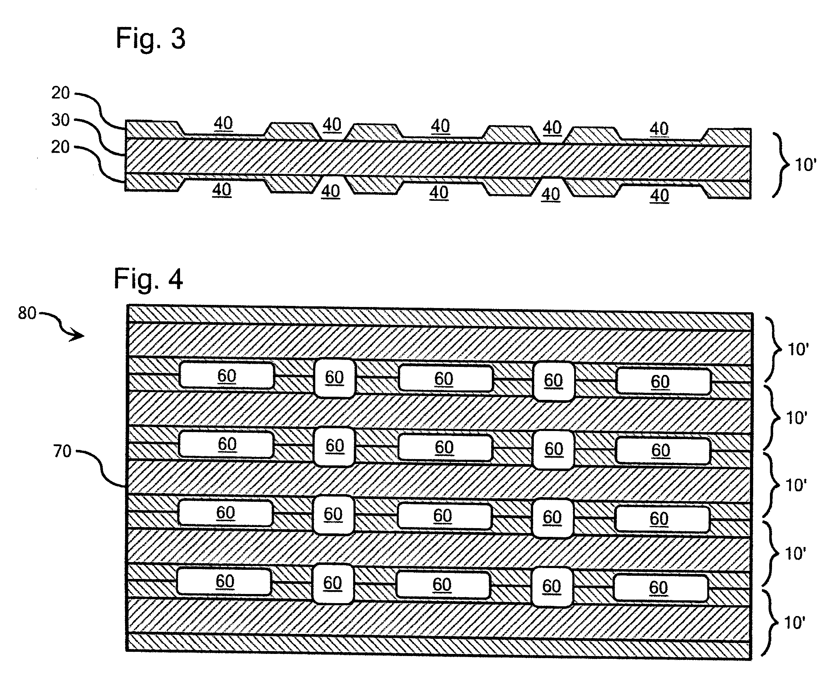

As is noted above, the present disclosure relates to methods for fabricating fluidic modules. The present disclosure is also directed to novel fluidic modules and reactors formed there from. The fluidic module fabrication methodology of the present disclosure is illustrated in Figs. 1-4. According to the methodology, a heterogeneous channel-forming laminate 10 is provided and comprises one or more mold-engaging layers 20 and a laminate backbone 30 (see Fig. 1). Fluidic channel components 40 are formed in the channel-forming laminate 10 by pressing elements of a channel-forming mold 50 into engagement with the mold-engaging layers 20 of the channel forming laminate 10 at a molding temperature T_{M} (see Figs. 2 and 3). The pressed channel-forming laminate 10' is then stacked with a plurality of complementary pressed channel forming laminates to define a plurality of fluidic channels 60 in a stacked laminate structure 70 (see Fig. 4).

The stacked laminate structure 70 is sealed at a sealing temperature Tₛ that is less than the molding temperature T_{M} and above a softening point temperature of the mold-engaging layers 20 to form a fluidic module 80 including fluidic channels 60 characterized by robust sealed interfaces, rounded corners, and minimal stress concentration points. More specifically, the sealing temperature Tₛ is selected to utilize surface tension effects to generate rounded edges and eliminate sharp angles in the fluidic channels 60. It is noteworthy that the fluidic channels 60 typically define channel widths of approximately 1-10 mm, channel depths of approximately 1-3 mm, and can be sealed without the aid of glass frit or other types of granulated glass sealing agents.

To facilitate the aforementioned fabrication process, the mold-engaging layers 20 are provided as vitreous bodies defining a molding viscosity µ_{M}. The laminate backbone 30 is also provided as a vitreous body defining a supportive viscosity µ_{B}. The molding viscosity µ_{M} of the mold-engaging layer is less than the supportive viscosity µ_{B} of the laminate backbone at the molding temperature T_{M}. Preferably, the molding viscosity µ_{M} of the mold-engaging layer and the supportive viscosity µ_{B} of the laminate backbone define a viscosity ratio of at least approximately 100:1 at the sealing temperature Tₛ. The present inventors have recognized that channel forming laminates constructed in this manner provide fluidic channels 60 where geometrical or dimensional faults in the channels are minimized. Channel slumping, which also tends to occur during heat treatment, is also minimized.

By way of illustration, and not limitation, it is contemplated that the molding viscosity µ_{M} of the mold-engaging layer 20 will preferably be between approximately 1×10⁷ Poise and approximately 1×10⁸ Poise at the sealing temperature Tₛ, while the supportive viscosity µ_{B} of the laminate backbone 30 will be at least approximately 1×10¹⁰ Poise at the sealing temperature Tₛ. In this manner, the laminate backbone 30 is sufficiently stiff to prevent macroscopic viscous deformation of the module during sealing, while the viscosity of the mold engaging layers 20 is low enough for robust bonding and high enough to prevent slumping during heat treatment.

Although the mold-engaging layer 20 can be provided in a variety of conventional and yet-to-be developed glass and glass-ceramic forms, according to one contemplated embodiment, the mold engaging layer 20 comprises a borosilicate glass composition. Other suitable compositions for the mold-engaging layer 20 include, but are not limited to, Aluminosilicate, Cordierite glasses, Phosphate glasses, Borate glasses, Chalcogenide glasses, etc. The mold engaging layer 20 typically defines the outermost layer of the channel forming laminate 10 and may be coated or uncoated.

Similarly, although the laminate backbone 30 can be provided in a variety of conventional and yet-to-be developed glass and glass-ceramic forms, according to one contemplated embodiment, the laminate backbone 30 comprises an alkaline earth aluminosilicate glass. Preferably, the glass of the laminate backbone 30 and the glass of the mold engaging layer 20 should both be chemically compatible, i.e., the two glasses should not generate side reactions in the laminate, such as crystallization, phase separation or interdiffusion-induced peak stress generation at the interface of the two glasses. Suitable sheet glass compositions meeting the viscosity specifications identified herein for the laminate backbone 30 and the mold engaging layer 20 are commercially available from Corning Incorporated, Corning, NY.

In particular embodiments of the present invention, the laminate backbone can be a fusion-formed glass. As will be appreciated by those familiar with glass fabrication technology, Coming Incorporated has developer a process known as the fusion process to form high quality thin glass sheets that can be used in a variety of devices. The fusion process is a preferred technique for producing glass sheets because the glass sheets produced by this process have surfaces with superior flatness and smoothness when compared to glass sheets produced by other methods. The general fusion process is described in numerous publications, such as U.S. Pat. Nos. 3,338,696 and 3,682,609, pertinent portions of the disclosures of which are incorporated herein by reference.

In the context of the borosilicate and fusion glass compositions noted above, it is contemplated that the molding temperature T_{M} will be between approximately 1000 °C and approximately 1150 °C and is maintained for a duration of between approximately 15 minutes and approximately 90 minutes. For example, in one contemplated embodiment, the molding temperature T_{M} is approximately 1050°C and is maintained for approximately 1 hour. Similarly, it is contemplated that the sealing temperature Tₛ will be between approximately 750 °C and approximately 850 °C and is maintained for a duration of between approximately 15 minutes and approximately 60 minutes. In many cases, the sealing temperature Tₛ will be approximately 20°C above the softening point temperature of the mold-engaging layer 20. In one contemplated embodiment for a glass having a softening point temperature of 785°C, the sealing temperature Ts will be approximately 805°C and is maintained for a duration of approximately 40 minutes. In another contemplated embodiment for a glass having a softening point temperature of 975°C, the sealing temperature Tₛ will be approximately 990°C and is maintained for a duration of approximately 40 minutes.

Although, in the illustrated embodiment, the heterogeneous channel-forming laminate 10 comprises a pair of mold-engaging layers 20 with the laminate backbone 30 interposed there between, a variety of laminate configurations are contemplated in the present disclosure, including those where a single mold engaging layer 20 and laminate backbone is used. Similarly, although the illustrated embodiment shows a mold configuration where opposing portions of a channel-forming mold 50 are pressed into engagement with a pair of mold-engaging layers 20, it is contemplated that the channel forming mold 50 may be provided in a variety of configurations, including more or less mold portions. Typically, it will be advantageous to provide channel forming molds comprising graphite molding plates.

According to one aspect of the present methodology, the mold-engaging layer 20 and the laminate backbone 30 are selected so that they define mismatched coefficients of thermal expansion and the mismatch is significant enough to generate strength-enhancing surface compression in the stacked laminate structure of the fluidic module 80. If low residual stress is contemplated, the mismatch may be less than approximately 50 ppm.

The devices resulting from the methods disclosed herein are generally useful in performing any process that involves mixing, separation, extraction, crystallization, precipitation, or otherwise processing fluids or mixtures of fluids, including multiphase mixtures of fluids-and including fluids or mixtures of fluids including multiphase mixtures of fluids that also contain solids-within a microstructure. The processing may include a physical process, a chemical reaction defined as a process that results in the interconversion of organic, inorganic, or both organic and inorganic species, a biochemical process, or any other form of processing. The following non-limiting list of reactions may be performed with the disclosed methods and/or devices: oxidation; reduction; substitution; elimination; addition; ligand exchange; metal exchange; and ion exchange. More specifically, reactions of any of the following non-limiting list may be performed with the disclosed methods and/or devices: polymerisation; alkylation; dealkylation; nitration; peroxidation; sulfoxidation; epoxidation; ammoxidation; hydrogenation; dehydrogenation; organometallic reactions; precious metal chemistry/ homogeneous catalyst reactions; carbonylation; thiocarbonylation; alkoxylation; halogenation; dehydrohalogenation; dehalogenation; hydroformylation; carboxylation; decarboxylation; amination; arylation; peptide coupling; aldol condensation; cyclocondensation; dehydrocyclization; esterification; amidation; heterocyclic synthesis; dehydration; alcoholysis; hydrolysis; ammonolysis; etherification; enzymatic synthesis; ketalization; saponification; isomerisation; quaternization; formylation; phase transfer reactions; silylations; nitrile synthesis; phosphorylation; ozonolysis; azide chemistry; metathesis; hydrosilylation; coupling reactions; and enzymatic reactions.

For the purposes of describing and defining the present invention, it is noted that a vitreous body comprises a glass or glass-ceramic body and cannot exist as a glass frit or other granulated glass composition. Further, it is noted that a fluidic module is a device that provides fluid flow channels for one or more fluids within its confines. It is also noted that recitations herein of "at least one" component, element, etc., should not be used to create an inference that the alternative use of the articles "a" or "an" should be limited to a single component, element, etc.

It is noted that terms like "preferably," "commonly," and "typically," when utilized herein, are not utilized to limit the scope of the claimed invention or to imply that certain features are critical, essential, or even important to the structure or function of the claimed invention. Rather, these terms are merely intended to identify particular aspects of an embodiment of the present disclosure or to emphasize alternative or additional features that may or may not be utilized in a particular embodiment of the present disclosure.

Having described the subject matter of the present disclosure in detail and by reference to specific embodiments thereof, it will be apparent that modifications and variations are possible without departing from the scope of the invention defined in the appended claims. More specifically, although some aspects of the present disclosure, are identified herein as preferred or particularly advantageous, it is contemplated that the present disclosure is not necessarily limited to these aspects.

It is noted that one or more of the following claims utilize the term "wherein" as a transitional phrase. For the purposes of defining the present invention, it is noted that this term is introduced in the claims as an open-ended transitional phrase that is used to introduce a recitation of a series of characteristics of the structure and should be interpreted in like manner as the more commonly used open-ended preamble term "comprising".

In the present description and appended claims, in each case where a numerical value is introduced by the term "approximately", "about" or any similar or equivalent term, it is to be understood that the exact numerical value indicated after "approximately", "about" or any similar or equivalent term, is comprised in the embodiment in question and is considered herein to be a particularly advantageous embodiment thereof.

## Claims

1. A method of fabricating a fluidic module (80) comprising fluidic channels (60) defined within a glass or glass-ceramic structure, the method comprising:
providing a heterogeneous channel-forming laminate (10) comprising a mold-engaging layer (20) and a laminate backbone (30), wherein the laminate backbone (30) comprises a vitreous body defining a supportive viscosity µ_{B};
pressing a channel-forming mold (50) into engagement with the mold-engaging layer (20) of the channel forming laminate (10) at a molding temperature T_{M} to form fluidic channel components (40) in the channel-forming laminate (10), wherein the molding viscosity µ_{M} of the mold-engaging layer is less than the supportive viscosity µ_{B} of the laminate backbone at the molding temperature T_{M},
stacking the pressed channel-forming laminate (10') with a plurality of complementary pressed channel forming laminates (10') to define a plurality of fluidic channels (60) in a stacked laminate structure (70); and
sealing the plurality of fluidic channels (60) in the stacked laminate structure (70) at a sealing temperature T_{S} that is less than the molding temperature T_{M} and above a softening point temperature of the mold-engaging layer (20).

2. The method as claimed in claim 1 wherein:
the heterogeneous channel-forming laminate (10) comprises a pair of mold-engaging layers (20) with the laminate backbone (30) interposed there between; and
opposing portions of the channel-forming mold (50) are pressed into engagement with the pair of mold-engaging layers (20).

3. The method as claimed in either of claims 1 and 2 wherein:
the mold-engaging layer (20) and the laminate backbone (30) define mismatched coefficients of thermal expansion; and
the coefficient of thermal expansion mismatch is significant enough to generate strength-enhancing surface compression in the stacked laminate structure (70).

4. The method as claimed in any of claims 1-3 wherein the mold-engaging layer (20) and the laminate backbone (30) define coefficients of thermal expansion that are mismatched by less than approximately 50 ppm.

5. The method as claimed in any of claims 1-4 wherein the molding temperature T_{M} is between approximately 1000 °C and approximately 1150 °C and is maintained for a duration of between approximately 15 min and approximately 90 min.

6. The method as claimed in any of claims 1-5 wherein the sealing temperature is between approximately 750 °C and approximately 850 °C and is maintained for a duration of between approximately 15 min and approximately 60 min.

7. The method as claimed in any of claims 1-6 wherein the fluidic channels (60) are sealed without the aid of granulated glass sealing agents.

8. The method as claimed in any of claims 1-7 wherein the sealing temperature T_{S} and sealing duration are sufficient to utilize surface tension effects to generate rounded edges and eliminate sharp angles in the fluidic channels (60).

9. The method as claimed in any of claims 1-8 wherein the mold-engaging layer (20) comprises a borosilicate glass composition.

10. The method as claimed in any of claims 1-9 wherein the molding viscosity µ_{M} of the mold-engaging layer (20) and the supportive viscosity µ_{B} of the laminate backbone (30) define a viscosity ratio of at least approximately 100:1 at the sealing temperature T_{S}.

11. The method as claimed in any of claims 1-10 wherein the molding viscosity µ_{M} of the mold-engaging layer (20) is between approximately 1x10⁶ Pa.s (1x10⁷ Poise) and approximately 1x10⁷ Pa.s (1x10⁸ Poise) at the sealing temperature T_{S}.

12. The method as claimed in any of claims 1-11 wherein the supportive viscosity µ_{B} of the laminate backbone (30) is at least approximately 1x10⁹ Pa.s (1x10¹⁰ Poise) at the sealing temperature T_{S}.

13. The method as claimed in any of claims 1-12 wherein the channel-forming mold (50) comprises a graphite molding plate.

14. A fluidic module (80) comprising a stacked laminate structure (70), wherein the stacked laminate structure (70) comprises a stacked plurality of complementary channel forming laminates (10') defining a plurality of fluidic channels (60) in the stacked laminate structure (70), wherein:
each of the channel forming laminates (10') comprises a heterogeneous channel-forming laminate (10) comprising a mold-engaging layer (20) and a laminate backbone (30);
the mold-engaging layer (20) comprises a vitreous body defining a molding viscosity µ_{M},
the laminate backbone (30) comprises a vitreous body defining a supportive viscosity µ_{B};
the molding viscosity µ_{M} of the mold-engaging layer (20) is less than the supportive viscosity µ_{B} of the laminate backbone (30) above the softening point temperature of the mold-engaging layer (20).

15. The fluidic module as claimed in claim 14 wherein:
the mold-engaging layer (20) and the laminate backbone (30) define mismatched coefficients of thermal expansion; and
the coefficient of thermal expansion mismatch is significant enough to generate strength-enhancing surface compression in the stacked laminate structure (70).

## Patentansprüche

1. Verfahren zum Herstellen eines fluidischen Moduls (80), das fluidische Kanäle (60) umfasst, welche innerhalb einer Glas- oder Glaskeramikstruktur definiert sind, wobei das Verfahren umfasst:
Bereitstellen eines heterogenen kanalbildenden Laminats (10), das eine formeingreifende Schicht (20) und eine Laminatstützschicht (30) umfasst, wobei die Laminatstützschicht (30) einen Glaskörper umfasst, der eine Stützviskosität µ_{B} definiert,
Pressen einer kanalbildenden Form (50) in Eingriff mit der formeingreifenden Schicht (20) des kanalbildenden Laminats (10) bei einer Formungstemperatur T_{M}, um fluidische Kanalkomponenten (40) im kanalbildenden Laminat (10) zu erzeugen, wobei die Formungsviskosität µ_{M} der formeingreifenden Schicht kleiner als die Stützviskosität µ_{B} der Laminatstützschicht bei der Formungstemperatur T_{M} ist,
Stapeln des gepressten kanalbildenden Laminats (10') mit mehreren komplementären gepressten kanalbildenden Laminaten (10'), um mehrere fluidische Kanäle (60) in einer gestapelten Laminatstruktur (70) zu definieren, und
Abdichten der mehreren fluidischen Kanäle (60) in der gestapelten Laminatstruktur (70) bei einer Abdichtungstemperatur T_{S}, die kleiner als die Formungstemperatur T_{M} ist und oberhalb einer Erweichungspunkttemperatur der formeingreifenden Schicht (20) liegt.

2. Verfahren nach Anspruch 1, wobei:
das heterogene kanalbildende Laminat (10) ein Paar von formeingreifenden Schichten (20) mit der Laminatstützschicht (30) umfasst, welche dazwischen angeordnet ist, und
gegenüberliegende Teile der kanalbildenden Form (50) in Eingriff mit dem Paar von formeingreifenden Schichten (20) gepresst werden.

3. Verfahren nach Anspruch 1 oder 2, wobei:
die formeingreifende Schicht (20) und die Laminatstützschicht (30) nicht zusammenpassende thermische Ausdehnungskoeffizienten definieren, und
die Fehlanpassung der thermischen Ausdehnungskoeffizienten groß genug ist, eine festigkeitserhöhende Oberflächenkompression in der gestapelten Laminatstruktur (70) zu erzeugen.

4. Verfahren nach einem der Ansprüche 1-3, wobei die formeingreifende Schicht (20) und die Laminatstützschicht (30) thermische Ausdehnungskoeffizienten definieren, die eine Fehlanpassung von weniger als ca. 50 ppm aufweisen.

5. Verfahren nach einem der Ansprüche 1-4, wobei die Formungstemperatur T_{M} zwischen etwa 1000 °C und etwa 1150 °C liegt und über eine Dauer von etwa 15 min bis etwa 90 min aufrechterhalten wird.

6. Verfahren nach einem der Ansprüche 1-5, wobei die Abdichtungstemperatur zwischen etwa 750 °C und etwa 850 °C liegt und über eine Dauer von etwa 15 min bis etwa 60 min aufrechterhalten wird.

7. Verfahren nach einem der Ansprüche 1-6, wobei die fluidischen Kanäle (60) ohne Einsatz von granulierten Glasabdichtungsmittein abgedichtet werden.

8. Verfahren nach einem der Ansprüche 1-7, wobei die Abdichtungstemperatur T_{S} und die Abdichtungsdauer ausreichend sind, Oberflächenspannungseffekte zu nutzen, um abgerundete Kanten zu erzeugen und spitze Winkel in den fluidischen Kanälen (60) zu beseitigen.

9. Verfahren nach einem der Ansprüche 1-8, wobei die formeingreifende Schicht (20) eine Borsilikat-Glaszusammensetzung umfasst.

10. Verfahren nach einem der Ansprüche 1-9, wobei die Formungsviskosität µ_{M} der formeingreifenden Schicht (20) und die Stützviskosität µ_{B} der Laminatstützschicht (30) ein Viskositätsverhältnis von mindesten 100:1 bei der Abdichtungstemperatur T_{S} definieren.

11. Verfahren nach einem der Ansprüche 1-10, wobei die Formungsviskosität µ_{M} der formeingreifenden Schicht (20) zwischen etwa 1x10⁶ Pa.s (1x10⁷ Poise) und etwa 1x10⁷ Pa.s (1x10⁸ Poise) bei der Abdichtungstemperatur T_{S} beträgt.

12. Verfahren nach einem der Ansprüche 1-11, wobei die Stützviskosität µ_{B} der Laminatstützschicht (30) mindestens etwa 1x10⁹ Pa.s (1x10¹⁰ Poise) bei der Abdichtungstemperatur T_{S} beträgt.

13. Verfahren nach einem der Ansprüche 1-12, wobei die kanalbildende Form (50) eine Grafit-Formplatte umfasst.

14. Fluidisches Modul (80), das eine gestapelte Laminatstruktur (70) umfasst, wobei die gestapelte Laminatstruktur (70) mehrere gestapelte komplementäre kanalbildende Laminate (10') umfasst, die mehrere fluidische Kanäle (60) in der gestapelten Laminatstruktur (70) definieren, wobei:
jedes der kanalbildenden Laminate (10') ein heterogenes kanalbildendes Laminat (10) umfasst, welches eine formeingreifende Schicht (20) und eine Laminatstützschicht (30) umfasst,
die formeingreifende Schicht (20) einen Glaskörper umfasst, der eine Formungsviskosität µ_{M} definiert,
die Laminatstützschicht (30) einen Glaskörper umfasst, der eine Stützviskosität µ_{B} definiert,
die Formungsviskosität µ_{M} der formeingreifenden Schicht (20) kleiner als die Formungsviskosität µ_{B} der Laminatstützschicht (30) oberhalb der Erweichungspunkttemperatur der formeingreifenden Schicht (20) ist.

15. Fluidisches Modul nach Anspruch 14, wobei:
die formeingreifende Schicht (20) und die Laminatstützschicht (30) nicht zusammenpassende thermische Ausdehnungskoeffizienten definieren, und
die Fehlanpassung der thermischen Ausdehnungskoeffizienten groß genug ist, eine festigkeitserhöhende Oberflächenkompression in der gestapelten Laminatstruktur (70) zu erzeugen.

## Revendications

1. Procédé de fabrication d'un module fluidique (80) comprenant des canaux fluidiques (60) définis à l'intérieur d'une structure en verre ou en vitrocéramique, le procédé comprenant :
la fourniture d'un stratifié hétérogène utile à la formation de canaux (10) comprenant une couche de prise de moule (20) et un squelette de stratifié (30), dans lequel le squelette de stratifié (30) comprend un corps vitreux définissant une viscosité de support µ_{B} ;
la compression d'un moule apte à former des canaux (50) en prise avec la couche de prise de moule (20) du stratifié utile à la formation de canaux (10) à une température de moulage T_{M} pour former des composants de canaux fluidiques (40) dans le stratifié, utile à la formation de canaux (10), dans lequel la viscosité de moulage µ_{M} de la couche de prise de moule est inférieure à la viscosité de support µ_{B} du squelette de stratifié à la température de moulage T_{M},
l'empilement du stratifié, utile à la formation de canaux, comprimé (10') avec plusieurs stratifiés, utiles à la formation de canaux, comprimés complémentaires (10') pour définir plusieurs canaux fluidiques (60) dans une structure de stratifiés empilés (70) ; et
le scellement des plusieurs canaux fluidiques (60) dans la structure de stratifiés empilés (70) à une température de scellement T_{S} qui est inférieure à la température de moulage T_{M} et supérieure à une température de point de ramollissement de la couche de prise de moule (20).

2. Procédé selon la revendication 1, dans lequel :
le stratifié hétérogène utile à la formation de canaux (10) comprend une paire de couches de prise de moule (20) avec le squelette de stratifié (30) intercalé entre celles-ci ; et
des portions opposées du moule apte à former des canaux (50) sont comprimées en prise avec la paire de couches de prise de moule (20).

3. Procédé selon l'une quelconque des revendications 1 et 2 dans lequel :
la couche de prise de moule (20) et le squelette de stratifié (30) définissent des coefficients de dilatation thermique décalés ; et
le coefficient de décalage de dilatation thermique est assez important pour produire une compression de surface promouvant la résistance dans la structure de stratifiés empilés (70).

4. Procédé selon l'une quelconque des revendications 1-3, dans lequel la couche de prise de moule (20) et le squelette de stratifié (30) définissent des coefficients de dilatation thermique qui sont décalés de moins d'approximativement 50 ppm.

5. Procédé selon l'une quelconque des revendications 1-4, dans lequel la température de moulage T_{M} est d'approximativement 1 000°C à approximativement 1150°C et est maintenue sur une durée d'approximativement 15 min à approximativement 90 min.

6. Procédé selon l'une quelconque des revendications 1-5, dans lequel la température de scellement est d'approximativement 750°C à approximativement 850°C et est maintenue sur une durée d'approximativement 15 min à approximativement 60 min.

7. Procédé selon l'une quelconque des revendications 1-6, dans lequel les canaux fluidiques (60) sont scellés sans l'aide d'agent de scellement de verre granulé.

8. Procédé selon l'une quelconque des revendications 1-7, dans lequel la température de scellement T_{S} et la durée de scellement sont suffisants pour utiliser des effets de tension de surface afin de produire des bords arrondis et d'éliminer les angles vifs dans les canaux fluidiques (60).

9. Procédé selon l'une quelconque des revendications 1-8, dans lequel la couche de prise de moule (20) comprend une composition de verre de borosilicate.

10. Procédé selon l'une quelconque des revendications 1-9, dans lequel la viscosité de moulage µ_{M} de la couche de prise de moule (20) et la viscosité de support µ_{B} du squelette de stratifié (30) définissent un rapport des viscosités d'au moins approximativement 100:1 à la température de scellement T_{S}.

11. Procédé selon l'une quelconque des revendications 1-10, dans lequel la viscosité de moulage µ_{M} de la couche de prise de moule (20) est d'approximativement 1 x 10⁶ Pa.s (1 x 10⁷ Poise) à approximativement 1 x 10⁷ Pa.s (1 x 10⁸ Poise) à la température de scellement T_{S}.

12. Procédé selon l'une quelconque des revendications 1-11, dans lequel la viscosité de support µ_{B} du squelette de stratifié (30) est au moins d'approximativement 1 x 10⁹ Pa.s (1 x 10¹⁰ Poise) à la température de scellement T_{S}.

13. Procédé selon l'une quelconque des revendications 1-12, dans lequel le moule apte à former des canaux (50) comprend une plaque de moulage en graphite.

14. Module fluidique (80) comprenant une structure de stratifiés empilés (70), dans lequel la structure de stratifiés empilés (70) comprend une pluralité de stratifiés, utiles à la formation de canaux, complémentaires, empilés (10'), définissant une pluralité de canaux fluidiques (60) dans la structure de stratifiés empilés (70), dans lequel :
chacun des stratifiés utile à la formation de canaux (10') comprend un stratifié hétérogène utile à la formation de canaux (10) comprenant une couche de prise de moule (20) et un squelette de stratifié (30) ;
la couche de prise de moule (20) comprend un corps vitreux définissant une viscosité de moulage µ_{M},
le squelette de stratifié (30) comprend un corps vitreux définissant une viscosité de support µ_{B},
la viscosité de moulage µ_{M} de la couche de prise de moule (20) est inférieure à la viscosité de support µ_{B} du squelette de stratifié (30) au-dessus de la température de point de ramollissement de la couche de prise de moule (20).

15. Module fluidique selon la revendication 14 dans lequel :
la couche de prise de moule (20) et le squelette de stratifié (30) définissent des coefficients de dilatation thermique décalés ; et
le coefficient de décalage de dilatation thermique est assez important pour produire une compression de surface promouvant la résistance dans la structure de stratifiés empilés (70).
